# EUROPEAN PATENT APPLICATION

(11) **EP 0 918 225 A2**
(43) Date of publication of application: **26.05.1999**
(21) Application number: 98309261.0
(22) Date of filing: 12.11.1998
(51) Int. Cl.: G01R 13/34, G01R 31/308

(54) **Electro-optic sampling oscilloscope**

(30) Priority: 19.11.1997 JP 318699/97
(71) Applicant: ANDO ELECTRIC CO., LTD., Tokyo 144 (JP); NIPPON TELEGRAPH AND TELEPHONE CORPORATION, Tokyo 160 (JP)
(72) Inventor: Takeuchi, Nobuaki, c/o Ando Electric Co. Ltd., Ora-ku, Tokyo (JP); Yanagisawa, Yoshiki, c/o Ando Electric Co. Ltd., Ora-ku, Tokyo (JP); Kikuchi, Jun, c/o Ando Electric Co. Ltd., Ora-ku, Tokyo (JP); Banjou, Nobukazu, c/o Ando Electric Co. Ltd., Ora-ku, Tokyo (JP); Endou, Yoshio, c/o Ando Electric Co. Ltd., Ora-ku, Tokyo (JP); Shinagawa, Mitsuru, Nippon Telegr. & Tel. Corp., Shinjuku-ku, Tokyo (JP); Nagatsuma, Tadao, Nippon Telegr. & Tel. Corp., Shinjuku-ku, Tokyo (JP); Xamada, Junzo, Nippon Telegr. & Tel. Corp., Shinjuku-ku, Tokyo (JP)
(74) Representative: Read, Matthew Charles

(57) **Abstract**

The present invention relates to an optic-electro sampling oscilloscope. A pulse circuit (11) is used for the purpose of pulsing a sampling signal from a sweep circuit (5) in the EOS oscilloscope. Here, a D/A conversion circuit (12) is provided for the purpose of varying the bias voltage with respect to the step recovery diode (41) which is comprised by the pulse circuit (11), and it is possible to variably set the delay time ΔT. By delay pulse circuit (10) having this type of structure, it is possible to delay the sampling pulse by delay time ΔT, pulse the sampling pulse and output it. Thereby, it is possible to omit the delay circuit and resolve unstable factors.

## Description

### BACKGROUND OF THE INVENTION

### Field of the Invention

The present invention relates to an electro-optic sampling oscilloscope which measures a measurement signal to be measured using optical pulses generated based on a signal from a pulse circuit which pulses sampling signals and, in particular, to an electro-optic sampling oscilloscope characterized by a pulse circuit for the purpose of pulsing the sampling signal.

This application is based on patent application No.Hei 9-318699 filed in Japan, the content of which is incorporated herein by reference.

### Description of the Related Art

It is possible to observe the waveform of a signal to be measured by coupling the electric field generated by the signals to be measured to an electro-optic crystal, causing laser light to enter this electro-optic crystal, and using the polarization state of the laser light. Here, it is possible to use this laser light in pulse form, and to conduct measurement with extremely high time resolution when the sampling of the signal to be measured is conducted. An electro-optic sampling oscilloscope employs an electro-optic probe which takes advantage of this phenomenon.

In comparison with conventional sampling oscilloscopes which employ electrical probes, such an electro-optic sampling oscilloscope (herein below termed an "EOS" oscilloscope) has the following characteristic features (Shinagawa, et al: "A High-Impedance Probe Based on Electo-Optic Sampling," Proceeding of the 15^{th} Meeting on Lightwave Sensing Technology, May 1995, pp 123-129):
(1) When signals are measured, a ground wire is not required, so that measurement is simplified.
(2) The metal pin which is at the lead end of the electro-optic probe is isolated from the circuit system, so that it is possible to realize a high input impedance, and as a result, the state at the point at which measurement is conducted is essentially free of fluctuations.
(3) Since optical pulses are employed, measurement is possible in a broad band up to the order of GHz.

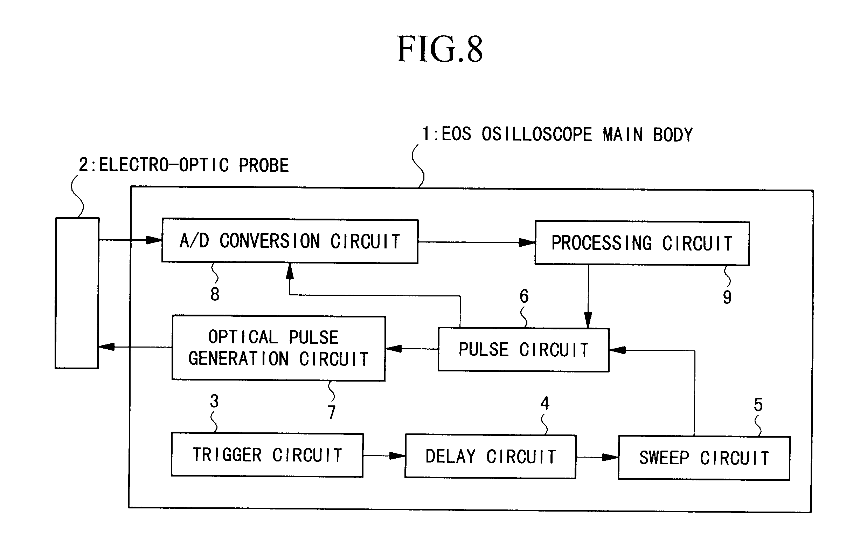

Firstly, the structure of an EOS oscilloscope will be explained using Figure 8.

The EOS oscilloscope comprises an EOS oscilloscope main body 1 and an electro-optic probe 2. Next, in the EOS oscilloscope main body 1, the trigger circuit 3 is a circuit related to the trigger signal which initiates measurement of the signal to be measured. Then, delay circuit 4 delays the signal from the trigger circuit 3 by only a delay time set for the purpose of conversion of the starting position of the sampling. Sweep circuit 5 uses the signal from delay circuit 4 as an input signal and generates a sampling signal for sampling, and this sampling signal is pulsed by pulse circuit 6. Then, based on the pulsed signal, optical pulse generation circuit 7 generates optical pulses.

The optical pulses from this optical pulse generation circuit 7 are supplied to the electro-optic probe 2 and undergo polarity conversion by an electro-optic element. The optical pulses which has undergone this polarization change undergo polarization detection by a polarization detection optical system (not shown in the Figure) in the electro-optic probe 2, and this signal is input into the EOS oscilloscope main body 1.

The signals from the electro-optic probe 2 undergo signal amplification and A/D conversion by the A/D conversion circuit 8. The processing circuit 9, which comprises a CPU (central processing unit) and the like, carries out the processing for the purpose of displaying the signal that is the subject of measurement.

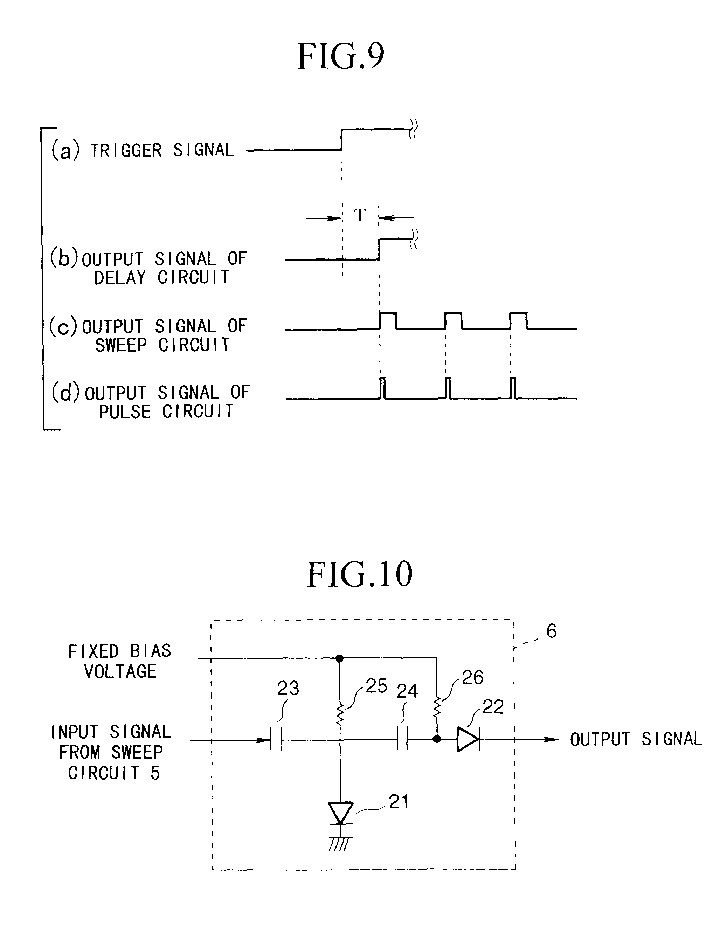

Next, an outline of the operation of the EOS oscilloscope shown in Figure 8 will be explained using Figure 9.

With regard to the trigger signal shown in part (a) in Figure 9, the delay circuit 4 outputs a signal delayed by a predetermined time only (in the Example in part (b) in the Figure, this is time T).

The sweep circuit 5 outputs a sampling signal for the purpose of sampling based on the output signal from the delay circuit 4 as shown in part (c) in Figure 9.

Since the width of the output signal from the sweep circuit 5 is too large to be used as the signal for the purpose of optical pulse output from the optical pulse generation circuit 7, the pulse circuit 6 pulses the signal from sweep circuit 5 as in part (d) in Figure 9.

Figure 10 is a diagram of a conventional example of pulse circuit 6. From Figure 10, the pulse circuit 6 comprises two step recovery diodes (hereinafter abbreviated as "SRD") 21 and 22, two condensers 23 and 24, and two resistors 25 and 26. A fixed bias voltage is supplied through the resistor 25 and resistor 26 as the bias voltage of the SRD 21 and the SRD 22. Then, the pulse circuit 6 outputs a pulsed signal from the SRD 22.

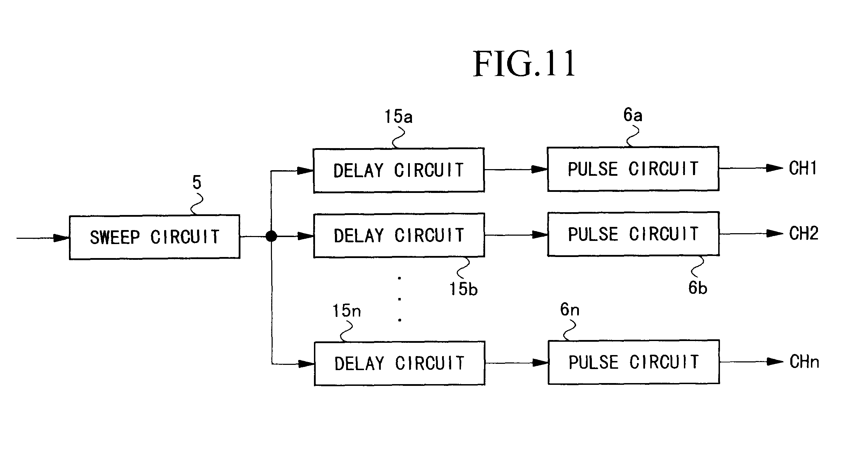

In addition, there are a plurality of channels in an EOS oscilloscope, and in situations where it is possible to measure signals for measurement in each channel, a pulse circuit is provided for each channel as shown in Figure 11. Here, Figure 11 is a diagram showing a part of the inside of an EOS oscilloscope main body 1. In the situation of Figure 11, there are from 1 to n channels, and as shown by reference symbols 6a to 6n, there are n number of pulse circuits provided. In addition, in order that it is possible to adjust the skew of the each channel, between each pulse circuit 6a ∼ 6n and sweep circuit 5, delay circuits 15a ∼ 15n are provided, and adjustment of the skew of each of these channels is carried out by these delay circuits 15a ∼ 15n.

However, in the above-mentioned EOS oscilloscope, a delay circuit and a pulse circuit are necessary so that the structure of the circuit of the EOS oscilloscope main body is complicated. In addition, in the delay circuit, there are unstable factors due to jitter and the like.

In addition, when there is a plurality of channels in the EOS oscilloscope, that is, a multi-channel situation, a pulse circuit is provided for each channel, but, in order to adjust for the skew of each channel, a delay circuit is necessary for each channel, and the structure of the circuit becomes complicated.

### SUMMARY OF THE INVENTION

The present invention was made in view of these circumstances and the object of the present invention is to provide an electro-optic sampling oscilloscope in which delay processing is also possible in the pulse circuit and, thereby, the circuit structure can be simplified.

In order to achieve the above-mentioned objective, the present invention provides an electro-optic sampling oscilloscope for conducting measurement of a signal to be measured using an optical pulse generated based on a signal from a pulse circuit which pulses sampling signals. And the pulse circuit comprises a step recovery diode, and the bias voltage of said step recovery diode is variable.

By this, when the delay processing is within the range which can be carried out by the pulse circuit, the delay circuit can be omitted, and it is possible to simplify the circuit structure. Moreover, when the delay circuit is omitted, the effect that unstable factors such as jitter are not present results.

Also the present invention provides an electro-optic sampling oscilloscope for conducting measurement of a signal to be measured for each channel using an optical pulse generated based on signals from a pulse circuit provided in each channel for the purpose of pulsing sampling signals. And the pulse circuit comprises a step recovery diode and the bias voltage of said step recovery diode is variable.

when there are a plurality of sampling channels in the EOS oscilloscope, a pulse circuit is provide for each channel, and it is possible to carry out time delay by varying the bias voltage of the step recovery diode which is contained in this pulse circuit. By this pulse circuit, it is also possible to adjust the skew of each channel and, thereby, it is not necessary to provide a delay circuit for each channel.

The reference symbols used in the claims are not influenced to the interpretation of the claims.

### BRIEF DESCRIPTION OF THE DRAWINGS

Figure 1 is a structural diagram is a delay pulse circuit of an EOS oscilloscope according to an embodiment of the present invention.

Figure 2 is a diagram showing the structure of an EOS oscilloscope according to an embodiment of the present invention.

Figure 3 is a circuit diagram according to an embodiment of the pulse circuit.

Figure 4 is a timing chart for the purpose of explaining the relationship between the output signal from the sweep circuit and the output signal from the delay pulse circuit.

Figure 5 is a diagram showing the relationship between the bias voltage and the delay time in a given step recovery diode.

Figure 6 is a diagram showing the structure between a delay pulse circuit and a sweep circuit when there are a plurality of channels in an EOS oscilloscope according to an embodiment of the present invention.

Figure 7 is a Figure showing a relationship between a delay time and a forward current in a given step recovery diode.

Figure 8 is a diagram showing the structure of an example of a conventional EOS oscilloscope.

Figure 9 is a timing chart for the purpose of explaining the operation of the EOS oscilloscope shown in Figure 8.

Figure 10 is a circuit diagram according to a conventional example of a pulse circuit.

Figure 11 is a diagram showing a conventional example of the structure between a pulse circuit and a sweep circuit when there are a plurality of channels in an EOS oscilloscope.

### DESCRIPTION OF PREFERRED EMBODIMENTS

The following embodiments does not restrict the interpretation of the claims relating to the present invention, and the combination of all the features explained in the embodiments is always not being indispensable means of solving the problem.

In the following, the electro-optic sampling oscilloscope according to one embodiment of the present invention will be explained with reference to Diagrams.

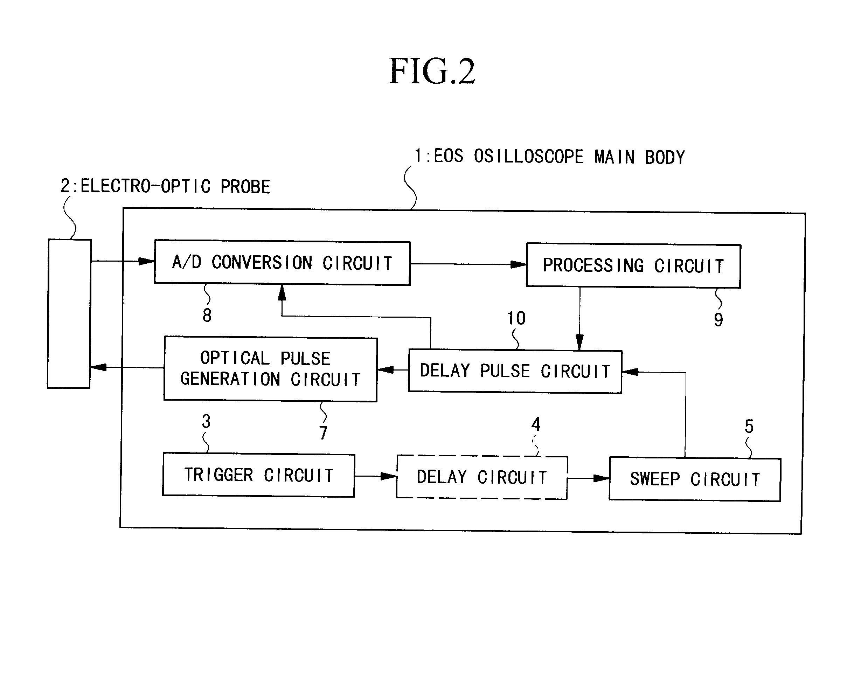

Firstly, the structure of an electro-optic sampling oscilloscope is explained using Figure 2.

The EOS oscilloscope comprises an EOS oscilloscope main body 1 and an electro-optic probe 2. Next, the EOS oscilloscope main body 1 comprises a trigger circuit 3, delay circuit 4, a sweep circuit 5, a delay pulse circuit 10, an optical pulse generation circuit 7, an A/D conversion circuit 8, and a processing circuit 9.

Here, trigger circuit 3 is a circuit related to trigger signals which initiate measurement with respect to measurement signals. In addition, delay circuit 4 delays the signal from the trigger signal 3 by only the delay time set for the purpose of changing the initial position of the sampling of the signal to be measured. In addition, the sweep circuit 5 generates a sampling signal for sampling, based on the signal from delay circuit 4.

Delay pulse circuit 10 uses, as input signals, sampling signals from the sweep circuit 5 and control signals from the processing circuit 9 which comprises a CPU (central processing unit) and the like. The delay pulse circuit 10 delays a sampling signal based on the control signal from processing circuit 9, pulses the sampling signal and outputs delayed and pulsed signal. In addition, the reason why it is necessary for pulsing is because the width of the sampling signal from the sweep circuit 5 is too large to be used as a signal for outputting optical pulses from optical pulse generation circuit 7. The optical pulse generation circuit 7 generates optical pulses based these pulsed signals.

The optical pulses from the optical pulse generation circuit 7 are supplied to the electro-optic probe 2 and undergo polarization change by an electro-optic element. The optical pulses which have undergone this polarization change are detected by a polarization detection system (not shown in the Figures), and these signals are input into the EOS oscilloscope main body 1.

The signal from the electro-optic probe 2 undergoes signal amplification and A/D conversion by the A/D conversion circuit 8. The processing circuit 9 carries out the processing for the purpose of displaying the signal which is the subject of measurement.

In addition, it is also possible for the delay pulse circuit 10 to carry out delay processing of the signal of the sweep circuit 5 within a certain time range. Therefore, when the necessary time delay is within the range which can be delayed by the delay pulse circuit 10, it is possible to omit the delay circuit 4.

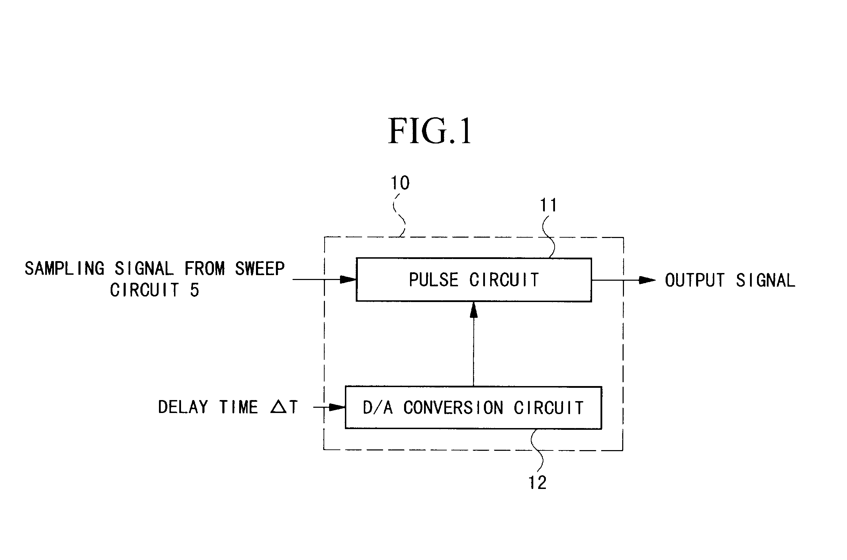

In addition, when called an "EOS oscilloscope", there are situations in which this comprises the EOS oscilloscope main body 1 and the electro-optic probe 2 of Figure 1, and situations in which there is only the EOS oscilloscope main body 1.

Figure 1 is a diagram showing the structure of a delay pulse circuit 10 in an EOS oscilloscope. Here, delay pulse circuit 10 comprises a pulse circuit 11 and a D/A conversion circuit 12. In addition, the information ΔT which relates to the delay time from processing circuit 9 and the sampling signal from sweep circuit 5 is used as an input signal, the delay pulse circuit 10 outputs signal which is the delayed by ΔT and pulsed sampling signal.

Here, the D/A conversion circuit 12 is provided for the conversion of digital information ΔT related to the delay time from the processing circuit 9 into an analogue signal. In addition, the pulse circuit 11 has a structure which includes an SRD. This SRD has the characteristic of generating delays in accordance with bias voltage. Here, the signal from the D/A conversion circuit 12 is input as bias voltage of SRD, and the pulse circuit 11 carries out the delay in accordance with the bias voltage and with respect to the sampling signal from the sweep circuit 5, pulses the sampling signal, and outputs the delayed and pulsed signal.

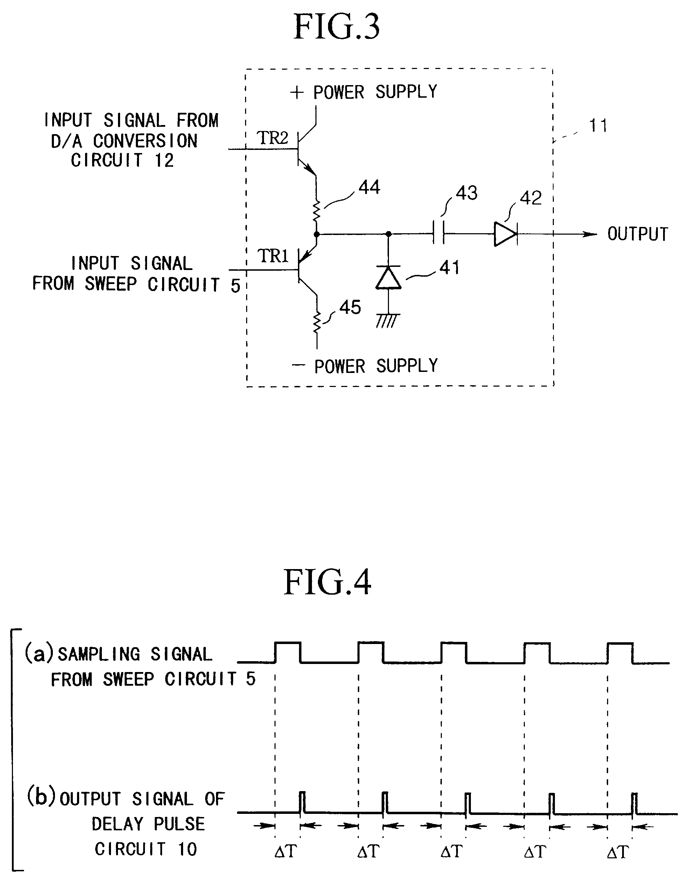

Figure 3 is a diagram showing an example of the circuit structure of a pulse circuit 11. From Figure 3, the pulse circuit 11 comprises two SRDs 41 and 42, a condenser 43, two resistors 44 and 45, and transistors TR1 and TR2. In Figure 3, the bias voltage which is the output from the D/A converter 12 is input to the base of the bias setting transistor TR2, and controls the source voltage of the transistor TR1 for amplifying the sampling signal from sweep circuit 5. In addition, by outputting the signal of the emitter of the transistor TR1 to the pulse output section which comprises SRD 41 and 42 and condenser 43, the bias voltage from the D/A converter 12, and the pulse from the sweep circuit 5 are supplied as a single signal. Next, by this input signal, the pulse output section delays the sampling signal in accordance with the bias voltage and pulses the sampling signal. And the delayed and pulsed signal is output from the SRD 42.

In addition, since the SRD has temperature characteristics, in order for operation at predetermined characteristics, a circuit (not shown in the Figures) is necessary for maintaining the temperature of these SRDs 41 and 42 within a specified range. As in Figure 3, with regard to SRDs 41 and 42, one input signal is sufficient, and SRD 41 and 42 can be arranged adjacently, and it is possible to shorten the connection electrical wiring for the purpose of temperature control. When it is possible to shorten the connection electrical wiring, the dispersion of heat by the electrical wiring can be reduced and stable temperature control is easy.

Next, the relationship between the output signals and inputs signals to the delay pulse circuit 10 will be explained using Figure 4.

With respect to the sampling signal from the sweep circuit 5 shown in part (a) in Figure 4, the delay pulse circuit 10 carries out delay of delay time ΔT which is set by processing circuit 9 and outputs the delayed and pulsed sampling signal as shown in part (b) in Figure 4. In addition, by delay pulse circuit 10, for example, the pulsed signal having a width of 200 [ps] is generated.

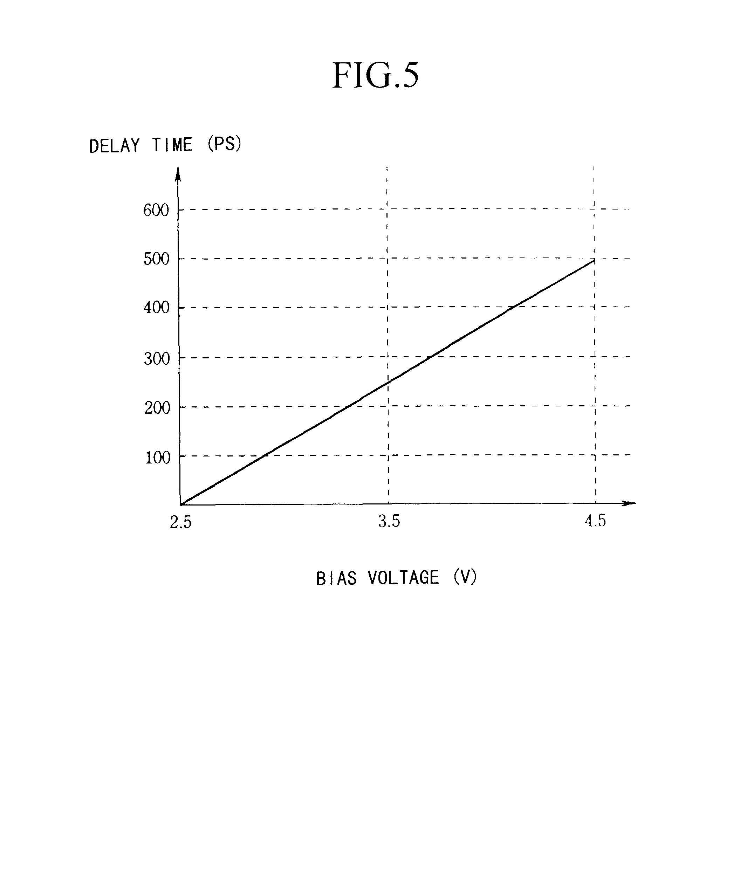

In addition, the processing circuit 9 stores information with regard to the relationship between the bias voltage and the delay time of the SRD which is comprised by pulse circuit 11 such as shown in Figure 5, for example, and, based on this information, determines a bias voltage which corresponds to the desired delay time, and outputs it to the D/A conversion circuit 12 as a digital signal. Here, "the desired delay time" is established by a user of the EOS oscilloscope via a setting section, not shown in the Figures, for the purpose of changing the initial measurement position of the signal to be measured. In the example of Figure 5, delay processing at a range of 0 ∼ 500 [ps] is possible.

As explained above, delay processing is made possible by variation ofthe bias voltage for pulse circuit 11. Therefore, when the delay processing is within the range which can be conducted by the pulse circuit 11, delay circuit 4 can be omitted, and it is possible to carry out simplification of the circuit structure. Moreover, when the delay processing exceeds the range which can be conducted by the pulse circuit 11, it is possible to conduct delay processing by combination with a delay circuit 4.

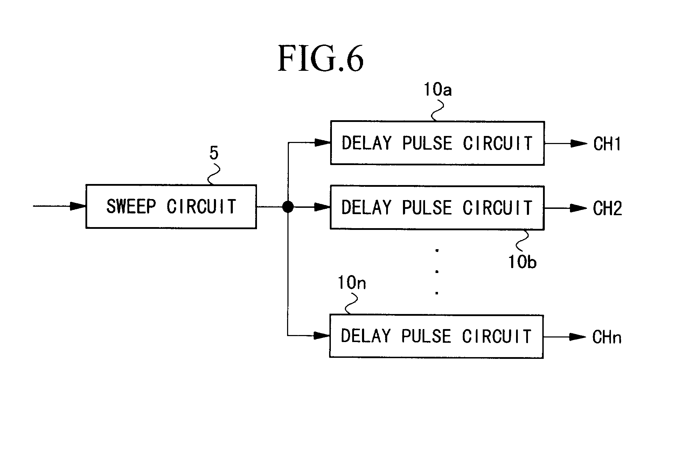

In addition, when there are a plurality of channels in the EOS oscilloscope, the delay pulse circuit 10 shown in Figure 1 may be provided for each channel as shown by references 10a to 10n in Figure 6. Since the delay pulse circuits 10a ∼ 10n can also carry out delay processing, based on this, it is not necessary to provide a delay circuit for each channel for the purpose of adjusting skew. In addition, Figure 6 is a diagram showing a part of the inside of the EOS oscilloscope main body 1. It is possible for the bias voltage to be varied and then input to each delay pulse circuit 10a ∼ 10n, for the purpose of adjusting the skew of each channel by signal wires which are not shown in the Figure.

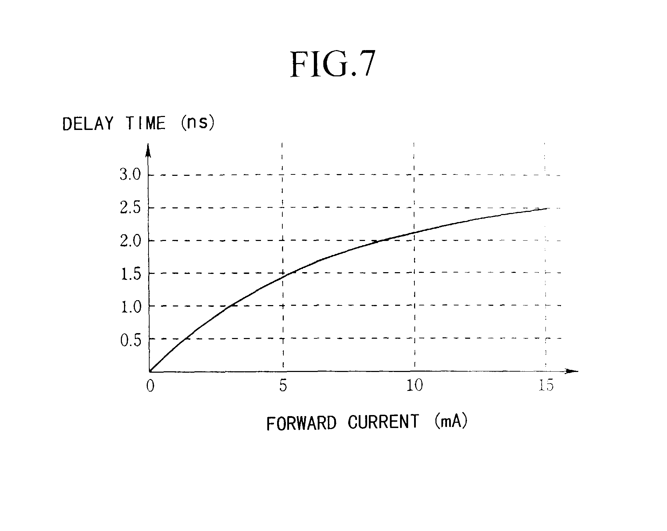

Moreover, as the delay pulse circuits 10a ∼ 10n for each channel and as the delay pulse circuit 10 of the EOS oscilloscope according to the above-mentioned embodiment, the explanation was made of controlling the delay time by the bias voltage, but it is also possible to control the delay time by the current. Moreover, in this situation, the processing circuit 7 stores information regarding the relationship between the forward current and the delay time of the SRD which is comprised by pulse circuit 11 such as shown in Figure 7, and based on this information, the current for the desired delay time is determined and is output to the D/A conversion circuit 12.

As explained above, the following effects can be obtained by the electro-optic sampling oscilloscope of the present invention.

A pulse circuit is provided in the EOS oscilloscope for the purpose of pulsing sampling signals. This pulse circuit has a step recovery diode as a component, the bias voltage of this step recovery diode is variable, and, thereby, delay processing can carried out. By this, when the delay processing is within the range which can be carried out by the pulse circuit, the delay circuit can be omitted, and it is possible to simplify the circuit structure. Moreover, when the delay circuit is omitted, the effect that unstable factors such as jitter are not present results.

In addition, when there are a plurality of sampling channels in the EOS oscilloscope, a pulse circuit is provide for each channel, and it is possible to carry out time delay by varying the bias voltage of the step recovery diode which is contained in this pulse circuit. By this pulse circuit, it is also possible to adjust the skew of each channel and, thereby, it is not necessary to provide a delay circuit for each channel.

In addition, a D/A conversion circuit is provided for the purpose of supplying bias voltage to the step recovery diode which makes up the pulse circuit. By this, it is possible to control the delay time from the processing circuit which comprises the CPU, and the like, via the D/A conversion circuit.

Because a single signal is supplied to the plurality of SRDs which make up the pulse circuit, it is possible to arrange the SRDs adjacently and, thereby, it is possible to shorten the connection wiring which is for the control of temperature. As a result, dispersion of heat by the wiring can be reduced, and stable temperature control is simple.

## Claims

1. An electro-optic sampling oscilloscope for conducting measurement of a signal to be measured using an optical pulse generated based on a signal from a pulse circuit (10) which pulses sampling signals, wherein
said pulse circuit (10) comprises a step recovery diode (41), and the bias voltage of said step recovery diode (41) is variable.

2. An electro-optic sampling oscilloscope for conducting measurement of a signal to be measured for each channel using an optical pulse generated based on signals from a pulse circuit (10a ∼ 10n) provided in each channel for the purpose of pulsing sampling signals, wherein:
said pulse circuit (10a ∼ 10n) comprises a step recovery diode (41) and the bias voltage of said step recovery diode (41) is variable.

3. An electro-optic sampling oscilloscope according to one of claim 1 or claim 2, wherein
said pulse circuit (10 or 10a ∼ 10n) further comprises a D/A conversion circuit (12) which D/A converts a delay time signal input as a digital signal and which supplies the output signal after said D/A conversion as bias voltage of the step recovery diode (41) comprised by said pulse circuit.

4. An electro-optic sampling oscilloscope according to one of claim 1 or claim 2, wherein
said pulse circuit (10 or 10a ∼ 10n) comprises a plurality of transistors (TR1, TR2) and a pulse output section having a plurality of step recovery diodes (41, 42);
a source voltage of the transistor for amplifying the sampling signal (TR1) is controlled by the transistor for setting the bias voltage (TR2), and
said pulse output section obtains signal from a predetermined terminal of the transistor for amplifying the sampling signal (TR1) and outputs delayed and pulsed signal.

5. An electro-optic sampling oscilloscope according to any one of claims 1 to 4, wherein
said pulse circuit (10 or 10a ∼ 10n) further comprises a circuit which maintains the temperature of the step recovery diode (41, 42) within a specific range.

6. Drive apparatus for an electro-optical probe comprising pulse generating means (6) to produce sequential pulses for driving the probe, and processing means (8, 9) for processing signals from the probe produced in response to the drive pulses **characterised in that** the pulse generating means (6) is responsive to an input control signal to selectively vary the phase of the pulses produced thereby.
